# EUROPÄISCHE PATENTSCHRIFT

(11) **EP 0 361 318 B1**
(45) Veröffentlichungstag und Bekanntmachung des Hinweises auf die Patenterteilung: **23.08.1995**
(21) Anmeldenummer: 89117500.2
(22) Anmeldetag: 21.09.1989
(51) Int. Cl.: H01L 29/06, H01L 29/74

(54) **Thyristor**
Thyristor
Thyristor

(30) Priorität: 27.09.1988 DE 3832709
(43) Veröffentlichungstag der Anmeldung: 04.04.1990
(73) Patentinhaber: Asea Brown Boveri Aktiengesellschaft, 68309 Mannheim (DE)
(72) Erfinder: Kmitta, Hubertus, D-6944 Hemsbach (DE); Kelberlau, Ulrich, Dr., D-6840 Lampertheim (DE); Langer, Kurt, Dr., D-6909 Walldorf (DE)
(74) Vertreter: Rupprecht, Klaus, Dipl.-Ing.

(56) Entgegenhaltungen:
- EP-A- 0 235 706
- DE-A- 2 812 658
- FR-A- 2 181 075
- PATENT ABSTRACTS OF JAPAN, Band 11, Nr. 271 (E-536)[2718], 3. September 1987; & JP-A-62 72 162
- J.K.GHANDI, Semiconductor Power Devices, J. Wiley & Sons-New York 1977, Seiten 56-72
- IEEE Transactions on Electron Devices, Vol. ED-27, No. 1, January 1980, seiten 261 bis 265

## Beschreibung

Die Erfindung bezieht sich auf einen Thyristor nach dem Oberbegriff des Anspruchs 1.

Ein solcher Thyristor ist in DE-A-29 00 747, Figur 1f dargestellt. Derartige in beiden Richtungen sperrende Thyristoren haben den Vorteil, daß beide sperrende pn-Übergänge auf der Kathodenseite an die Oberfläche treten und somit die Anode ohne besondere Vorkehrungen, wie z.B. Abstandshalter, auf ein leitfähiges und bezüglich des Wärmeausdehnungskoeffizienten angepaßtes Substrat gelötet werden können. Da sich diese Druckschrift lediglich auf ein Diffusionsverfahren bezieht, ist nicht ausgeführt, wie der Randabschluß der pn-Übergänge gestaltet werden könnte, um eine hohe Sperrspannung zu erzielen.

Eine übliche Thyristorgestaltung, mit der die Feldstärke an der Austrittsstelle der pn-Übergänge an die Oberfläche beherrscht werden kann, ist in Figur 6f der DE-A- 28 12 658 dargestellt. Beide pn-Übergänge enden dort in einem Graben und sind im Graben mit einer Passivierungsschicht abgedeckt.

In EP-A-02 35 706 ist ein planarer Thyristor mit Feldplatten angegeben.

Der Erfindung liegt die Aufgabe zugrunde, für einen isolationsdiffundierten, in beiden Richtungen sperrenden Thyristor eine Lösung für den Randabschluß anzugeben, die eine einfache Herstellbarkeit und eine hohe Sperrspannung ermöglicht.

Diese Aufgabe wird bei einem Thyristor nach dem Oberbegriff des Anspruchs 1 durch dessen kennzeichnende Merkmale gelöst.

Mehrere Möglichkeiten zur Gestaltung des Randabschlusses sind aus Ghandhi, J.K., Semiconductor Power Devices, Verlag Wiley and Sons, New York, 1977, Kap. 2.5, Seite 56 bis 72 bekannt. Daraus ist ein Randabschluß mit Guardringen, also feldbegrenzenden Ringen, bekannt. Ein solcher Randabschluß wird beim erfindungsgemäßen Thyristor für den in Blockierrichtung sperrenden pn-Übergang verwendet. Der in Sperrichtung sperrende pn-Übergang ist ohne Graben an die Oberfläche geführt und dort mit einer Passivierungsschicht abgedeckt. Ein auf solche Weise gestalteter planarer Thyristor läßt sich mit geringem Aufwand herstellen und weist hohe Sperrspannungen in beiden Richtungen auf.

Nach einer vorteilhaften Ausgestaltung durch eine gesonderte Diffusion der Feldringe und eines Randbereichs der kathodenseitigen Basiszone die Spannungsfestigkeit in Blockierrichtung noch erhöht werden.

Die Erfindung wird anhand eines in der Zeichnung dargestellten Ausführungsbeispiels näher erläutert.

Es zeigt:
- Fig. 1: einen Querschnitt durch den Randbereich eines planar passivierten Thyristors und
- Fig. 2: einen solchen Thyristor, bei dem die feldbegrenzenden Ringe und ein Randbereich der p⁺-Basiszone mit einem zusätzlichen Diffusionsprozeß hergestellt sind.

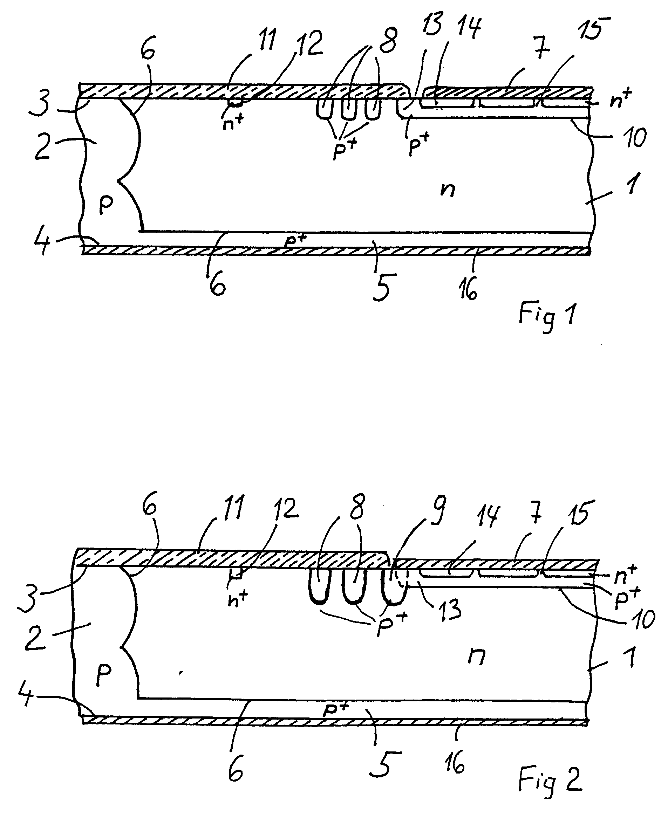

Fig. 1 zeigt einen Querschnitt durch den Randbereich eines Thyristors. Zur Herstellung eines solchen Thyristors wird eine n-leitende Siliziumscheibe 1 verwendet mit einer ersten Hauptfläche 3 und einer zweiten Hauptfläche 4. Eine Abgrenzung einzelner Thyristoren in der Siliziumscheibe 1 erfolgt mit einer Isolationsdiffusion, wobei mit einer Aluminiumquelle auf beiden Hauptflächen gearbeitet wird. Es entsteht dadurch ein p-leitender Bauelementerand 2. Mit einer Bordiffusion auf der Seite der zweiten Hauptfläche 4, der Anodenseite, wird eine p⁺-leitende Schicht 5 hergestellt und damit ein in Sperrichtung sperrender pn-Übergang 6. Als Folge der Isolationsdiffusion tritt der pn-Übergang nicht anodenseitig, sondern an der ersten Hauptfläche 3 an die Oberfläche. Es wurde festgestellt, daß bei Verzicht auf einen Passivierungsgraben, die Feldstärke am Ort des Austritts des sperrenden pn-Übergangs an der Oberfläche zwar etwas höher als beim Austritt in einen Graben ist, jedoch deutlich niedriger ist, als im Volumen des Bauelements. Die Feldstärke ist ohne weiteres beherrschbar durch Abdecken mit bekannten Passivierungsschichten 11.

Mit dem Bordiffusionsprozeß werden gleichzeitig auf der Kathodenseite, also der ersten Hauptfläche 3, eine p⁺-leitende Basisschicht 13 und feldbegrenzende Ringe 8 hergestellt. Die Basisschicht 13 bildet mit dem n-leitenden Substrat 1 einen in Blockierrichtung sperrenden pn-Übergang 10.

Schließlich werden mit einem Phosphor-Diffusionsprozeß ein n⁺-leitender Kathodenemitter 14 und ein channel stopper 12 hergestellt. Selbstverständlich werden alle Diffusionsprozesse unter Verwendung entsprechender Masken durchgeführt, womit im zuletztgenannten Diffusionsprozeß auch Emittershorts 15 hergestellt werden.

Die bereits erwähnte Passivierungsschicht 11 überdeckt den gesamten Kathodenbereich, also auch den channel stopper 12, die Feldringe 8 und den an die Oberfläche tretenden pn-Übergang 10 mit Ausnahme des Emitters 14 und des Gates, die von einer Metallisierung 7 bedeckt sind.

Auf der zweiten Hauptfläche 4 ist eine ganzflächige Anodenmetallisierung 16 aufgebracht.

Mit der in Fig. 1 dargestellten Anordnung wird auf vorteilhafte Weise erreicht, daß auf einen Passivierungsgraben völlig verzichtet werden kann, und damit die Herstellung des Thyristors wesentlich vereinfacht wird. Mit dem gewählten Randabschluß durch Feldringe 8 für den in Blockierrichtung sperrenden pn-Übergang 10 wird auch in Blockierrichtung eine hohe Sperrspannung erzielt.

Fig. 2 zeigt eine vorteilhafte Ausgestaltung für den Randabschluß mit Feldringen. Bei dieser Variante werden die Feldringe 8 nicht gleichzeitig mit der p⁺-leitenden Basisschicht 13 hergestellt, sondern in einem zusätzlichen Diffusionsprozeß. Mit diesem zusätzlichen Diffusionsprozeß wird auch ein Randbereich 9 der Basisschicht 13 hergestellt. Dieses Vorgehen ermöglicht es, den aktiven Bereich der Basisschicht 13 hinsichtlich dynamischer Eigenschaften zu optimieren unabhängig von Problemen des Sperrens. Für den Randbereich 9 kann ein Dotierungsprofil gewählt werden, das sich hinsichtlich Steilheit des Gradienten und der Dotierstoffkonzentration an der Oberfläche unterscheidet. Außerdem kann die Eindringtiefe des Randbereichs 9 und der Feldringe 8 größer sein, als die Eindringtiefe der Basisschicht 13.

## Patentansprüche

1. Thyristor mit
- einer ersten Hauptfläche (3) als Kathodenseite und einer zweiten Hauptfläche (4) als Anodenseite,
- einer zwischen diesen Hauptflächen (3,4) liegenden Folge von Schichten von jeweils abwechselndem Leitungstyp,
- einer durch Isolationsdiffusion hergestellten Zone (2), die den Thyristor an seinem Rand abschließt, wobei die Randzone (2) vom gleichen Leitungstyp wie die an die zweite Hauptfläche (4) grenzende Schicht (5) ist, und die Isolationsdiffusionszone (2) durch doppelseitige Trenndiffusion hergestellt ist, die einen bezüglich dieser Isolationsdiffusionszone (2) konkaven pn-Übergang (6) erzeugt,
- einem in Sperrichtung sperrenden pn-Übergang (6) und einem in Blockierrichtung sperrenden pn-Übergang (10), die beide ohne Graben direkt an der ersten Hauptfläche (3) austreten,
dadurch gekennzeichnet, daß
- sowohl der in Sperrichtung als auch der in Blockierrichtung sperrende pn-Übergang (6,10) auf der ersten Hauptfläche (3) mit einer Passivierungsschicht (11) abgedeckt ist,
- für den Randabschluß des blockierenden pn-Übergangs (10) feldbegrenzende Ringe (8) in der ersten Hauptfläche (3) angeordnet sind, die ebenfalls von der Passivierungsschicht (11) abgedeckt sind und daß
- für den Randabschluß des in Sperrichtung sperrenden pn-Übergangs (6) keine weiteren Maßnahmen zur Erniedrigung der Oberflächenfeldstärke durchgeführt sind.

2. Thyristor nach Anspruch 1, dadurch gekennzeichnet, daß zur Erhöhung der Sperrspannung bzw. zur Verringerung der Feldstärke und damit der erforderlichen Anzahl von feldbegrenzenden Ringen (8), diese Ringe (8) und ein Randbereich (9) der kathodenseitigen Basisschicht (13), also der p⁺-Basisschicht im Falle eines pnpn-Thyristors in einem gesonderten Diffusionsprozeß tiefer diffundiert sind, als die kathodenseitige Basisschicht (13) in ihrem Hauptgebiet.

## Claims

1. Thyristor having
- a first main area (3) as the cathode side and a second main area (4) as the anode side,
- a sequence, located between these main areas (3,4), of layers of respectively alternating conduction type,
- a region (2) which is produced by insulation diffusion and terminates the thyristor at its edge, the edge region (2) being of the same conduction type as the layer (5) adjoining the second main area (4), and the insulation diffusion region (2) being produced by means of double-sided isolation diffusion which produces a pn junction (6) which is concave with respect to this insulation diffusion region (2),
- a pn junction (6) which blocks in the reverse direction and a pn junction (10) which blocks in the blocking direction, both of which issue without a trench directly at the first main area (3),
characterized in that
- both the pn junction (6) which blocks in the reverse direction and the pn junction (10) which blocks in the blocking direction are covered at the first main area (3) with a passivation layer (11),
- for the edge termination of the blocking pn junction (10), field-limiting rings (8), which are likewise covered by the passivation layer (11), are arranged in the first main area (3), and in that
- for the edge termination of the pn junction (6) which blocks in the reverse direction, no further measures are carried out for lowering the surface field strength.

2. Thyristor according to Claim 1, characterized in that, for increasing the reverse voltage and for lowering the field strength and thus the required number of field-limiting rings (8), these rings (8) and an edge region (9) of the cathode-side base layer (13), that is to say the p⁺-type base layer in the case of a pnpn thyristor, are diffused in a separate diffusion process to a greater depth than the cathode-side base layer (13) in its main region.

## Revendications

1. Thyristor comportant
- une première surface (3) principale comme face de cathode et une seconde surface (4) principale comme face d'anode,
- entre lesdites surfaces (3, 4) principales, une succession de couches de nature de conductivité disposées en alternance,
- une zone (2) réalisée par diffusion d'isolement, laquelle zone délimite le thyristor au niveau de son bord, la zone périphérique (2) étant de même nature de conductivité que la couche (5) contiguë à la deuxième surface principale (4) et la zone (2) d'isolation étant formée par diffusion d'isolement sur deux faces, laquelle diffusion produit une transition pn (6) concave par rapport à ladite zone (2) d'isolation réalisée par diffusion,
- une transition pn (6) bloquante dans la direction de blocage et une transition pn (10) bloquante dans la direction d'arrêt, lesquelles transitions débouchent toutes deux directement, sans sillon de séparation, dans la première surface principale (3),
caractérisé par le fait que
- la transition pn (6) bloquante dans la direction de blocage et la transition pn (10) bloquante dans la direction d'arrêt dans la première surface principale (3) sont couvertes d'une couche (11) de passivation,
- pour la délimitation du bord de la transition pn (10) dans la direction d'arrêt, des anneaux (8) de limitation de champ sont disposés dans la première surface (3) principale, anneaux qui sont également couverts par la couche (11) de passivation et par le fait que
- pour la délimitation du bord de la transition pn (6) dans la direction de blocage, aucune disposition supplémentaire n'est mise en oeuvre pour réduire l'intensité de champ en surface.

2. Thyristor selon la revendication 1, caractérisé par le fait que pour augmenter la tension de blocage ou pour abaisser l'intensité de champ et par suite réduire le nombre des anneaux (8) de limitation de champ, lesdits anneaux (8) et une zone (9) périphérique de la couche (13) de base côté cathode, c'est-à-dire de la couche de base P⁺ dans le cas d'un transistor pnpn, sont diffusés au cours d'un processus de diffusion à une profondeur supérieure à la couche de base (13) côté cathode.
